# EUROPEAN PATENT APPLICATION

(11) **EP 2 288 021 A1**
(43) Date of publication of application: **23.02.2011**
(21) Application number: 09168242.7
(22) Date of filing: 20.08.2009
(51) Int. Cl.: H03F 1/56, H03F 1/02, H04B 1/04, H03F 3/24

(54) **Amplifier and method for amplification of an RF signal**

(71) Applicant: Alcatel Lucent, 75007 Paris (FR)
(72) Inventor: Wiegner, Dirk, 71409, Schwaikheim (DE); Jüschke, Patrick, 75428, Illingen (DE)
(74) Representative: Schmitt, Martin

(57) **Abstract**

The invention relates to an amplifier (1) for amplification of an RF input signal (RF in), comprising: an output stage (2), a modulator (3) for providing a signal-specific supply voltage (V) to the output stage (2) based on an envelope (4) of the RF input signal (RF in), and at least one adaptive output impedance matching unit (9a to 9c) for adapting an output impedance of the output stage (2), wherein the amplifier (1) is designed to adapt the at least one adaptive output matching unit (9a to 9c) based on the signal-specific supply voltage (V) that is provided to the output stage (2) and preferably also on a specific load condition. The invention also relates to a base station and to a communication network comprising such an amplifier (1), as well as to a method for power amplification using such an amplifier (1).

## Description

### Field of the Invention

The invention relates to the field of telecommunications, more specifically to the amplification of RF signals in communication networks, in particular with respect to multi-standard applications such as Software Defined Radio (SDR) or Cognitive Radio.

### Background

This section introduces aspects that may be helpful in facilitating a better understanding of the invention. Accordingly, the statements of this section are to be read in this light and are not to be understood as admissions about what is in the prior art or what is not in the prior art.

Conventional class-AB based power amplifiers have a fixed supply voltage (DC Drain supply voltage) which is matched only for a single standard application. Such class-AB based solutions having a fixed supply voltage only achieve moderate efficiency with a clear efficiency decrease for increased back-off operation (e.g. when signal peak-to-average increases, which typically is the case in multi-standard operations).

On a conceptual level, the Envelope Tracking concept is known for efficiency enhancement. In this concept, a signal-specific, adaptive supply voltage is provided to the power amplifier, and the supply voltage is dependent on an envelope of the RF input signal. However, due to the fact that the output matching has to be designed for one selected standard and signal (specific peak-to-average), this solution also shows a certain efficiency degradation when applying signals of different standards having different signal peak-to-average ratios, since the output matching is not necessarily ideally adapted to different application-specific conditions.

Thus, there is a need for improving efficiency and flexibility of RF amplifiers in order to support multi-standard (and possibly also multi-band) applications like e.g. Software Defined Radio (SDR) or Cognitive Radio.

### Summary of the Invention

According to one aspect, an amplifier for amplification of an RF input signal is provided, comprising: an output stage, a modulator for providing a signal-specific supply voltage to the output stage based on an envelope of the RF input signal, and at least one adaptive output impedance matching unit for adapting an output impedance of the output stage, wherein the amplifier is designed to adapt the at least one adaptive output matching unit based on a signal-specific supply voltage that is provided to the output stage and preferably also on a specific load situation. The signal-specific supply voltage is typically provided to the output stage by an envelope tracking, ET, modulator and thus depends on the envelope of the RF input signal, and thus also on a peak-to-average ratio of the RF input signal, the latter being itself related to a communication standard used for the RF input signal.

Since the required optimal load / output impedance is among others dependent on the transistor supply voltage and thus on the signal characteristic and the particularly addressed standard, an output matching network designed for one standard is not necessarily still efficiency optimized when applying different signals, communication standards or when the BTS load is changed. The idea of the proposed solution is thus to adapt the output matching specifically to the signal characteristic, i.e. to different addressed communication standards and related signal peak-to-average ratios, and possibly also to the particular Base Transceiver Station, BTS, load, by adding specific adaptive matching elements to the output matching of the envelope tracked (ET) amplifier. In order to improve the ET RF power amplifier output matching and thus its efficiency, a signal, standard, and possibly also BTS-load related adaptive output matching by use of switchable or tunable impedance matching elements / configurations may thus be provided.

In one embodiment, the amplifier unit is designed to derive at least one statistical property, in particular a mean value, from the signal-specific supply voltage, and to adapt the at least one adaptive output matching unit based on the at least one derived statistical property. The statistical distribution of the RF input signal of the currently used standard may be analyzed (clipping (signal dynamic reduction) may also be taken into account) in an analyzing unit, thus determining a signal-specific supply voltage (typically an average voltage) which is statistically most frequently required by the transistor of the output stage. For this signal-specific supply voltage, an optimal output impedance for the amplifier output matching may be found, thus allowing to implement an ET RF amplifier having a signal-specific output impedance which may be adapted by controlling the adaptive impedance matching unit(s) in an appropriate way.

In a further embodiment, the output stage comprises an amplifying (power) transistor, in particular a Field-Effect transistor, to which the signal-specific supply voltage is provided (typically to a Drain terminal thereof). It will be understood that the amplifier may be implemented using more than one amplifier stage, e.g. having an additional driver stage to which the signal-specific or a fixed supply voltage may be provided.

In another embodiment, at least one of the adaptive output matching units comprises a switching element for activating or deactivating at least one impedance matching element having fixed impedance. Depending on the currently used signal and communication standard, an output matching element of the adaptive output matching unit may be switched to an active state, thus changing the output impedance in a desired way, thus improving the RF amplifier efficiency and overall efficiency. The switching element may be implemented, for instance, as a switching diode, in particular as a PIN diode, or as a MEMS switch.

In yet another embodiment, at least one of the adaptive output matching units comprises a tunable impedance matching element, for example in the form of a tunable capacitor, the capacitance thereof being possibly adjustable.

One skilled in the art will appreciated that the amplifier may also comprise at least one frequency matching unit for matching an input impedance or an output impedance of the amplifier in dependence of a center frequency of the RF input signal. The amplifier unit may thus be devised as a multi-band amplifier for amplification of RF signals of different frequency bands, having adaptive frequency matching elements for adjusting the input and/or the output impedance of the amplifier to the currently amplified frequency band.

In one embodiment, the modulator is adapted to generate the supply voltage taking into account at least one statistical property, in particular a peak-to-average ratio, of the RF input signal. Typically, the ET modulator is adapted to generate a supply voltage which is essentially proportional to an envelope signal being provided to an input of the modulator. However, it may also be possible to modify the output signal (i.e. the supply voltage) of the modulator taking statistical properties of the RF input signal, in particular its peak-to-average ratio, into account. In such a way, a signal- and transmission standard-related configuration of the ET modulator may be provided.

A further aspect relates to an Envelope Elimination and Restoration, EER, amplifier comprising: an amplifier as described above, and a limiter for limiting the RF input signal which is provided to the output stage. The modulator provides the supply voltage to a (Drain) terminal of the transistor of the output stage. The EER amplifier differ essentially from an ET amplifier in that a limiter is provided for driving the output stage as a switching stage. In contrast thereto, in the ET amplifier, the amplitude modulation has to be added by the modulated supply voltage directly at the transistor's output, requiring a clearly larger bandwidth and more accurate time-delay adjustment.

A further aspect of the invention relates to a base station comprising at least one amplifier as described above. The amplifier may be devised as ET or EER amplifier and may in particular be implemented in an active antenna element of the base station, being connected to a baseband part via cabling.

In one embodiment, the amplifier is designed for adapting the at least one adaptive output matching unit based on a specific load condition of the base station. The load condition of the base station may be known or determined in the base station, in particular in the baseband part thereof. The load condition has an influence on the load provided to the output stage, and thus may also be taken into account for the determination of the output impedance to which the amplifier has to be matched.

The base station may be part of a communication network which may in particular be adapted to support multi-standard and/or multi-band applications such as Software Defined Radio (SDR) or Cognitive Radio.

Another aspect of the invention is implemented in a method for power amplification of an RF input signal in an amplifier, in particular of a base station of a communications network, the method comprising: adjusting an output impedance of an output stage of the amplifier by adapting at least one adaptive output matching unit of the output stage based on a signal-specific supply voltage that is provided from a modulator to the output stage.

In one variant, the step of adapting the at least one adaptive output matching unit comprises deriving at least one statistical property, in particular a mean value, of the signal-specific supply voltage, and adapting the at least one adaptive output matching unit based on the at least one derived statistical property of the currently amplified RF input signal. In this case, the statistical distribution of the signal of the currently used standard may be analyzed (clipping may also be taken into account), resulting in a signal-specific supply voltage which is statistically most frequently required by the transistor of the output stage. In dependence of the signal-specific voltage, the optimum output impedance for the amplifier output matching may be determined, thus increasing the amplifier's efficiency.

In another variant, the method further comprises: adapting the modulator for generating the supply voltage based on a statistical property, in particular a peak-to-average-ratio, of the RF input signal and/or based on a load condition of the base station. Among others, both the load condition and the peak-to-average ratio of the RF signal to be amplified may have an influence on the optimum supply voltage which has to be provided to the output terminal of the output stage.

It is also possible to adapt at least one of an input and an output impedance of the amplifier in dependence of a center frequency of the RF input signal, i.e. in addition to the signal-specific output matching, it is also possible to provide an additional frequency-dependent input and output matching for the amplifier. However, it will be understood that it is not necessary to combine the solution presented herein with frequency-dependent input and output matching: If only a single-band (but multi-standard) amplifier module is required, only the multi-standard capability of the RF power amplifier is needed and fixed matching networks being adapted to only a single center frequency may be employed.

A person of skill in the art will readily recognize that various steps of the above-described method can be performed by programmed computers. Herein, some embodiments are also intended to cover program storage devices, e.g., digital data storage media, which are machine or computer readable and encode machine-executable or computer-executable programs of instructions, wherein said instructions perform some or all of the steps of said above-described methods. The program storage devices may be, e.g., digital memories, magnetic storage media such as magnetic discs and magnetic tapes, hard drives, or optically readable digital data storage media. The embodiments are also intended to cover computers, in particular field programmable gate arrays (FPGA), application-specific integrated circuits (ASIC), or digital signal processors (DSP) programmed to perform the steps of the above-described method(s). Other hardware, conventional and/or custom, may also be included.

Further features and advantages are stated in the following description of exemplary embodiments, with reference to the figures of the drawing, which shows significant details, and are defined by the claims. The individual features can be implemented individually by themselves, or several of them can be implemented in any desired combination.

### Brief Description of the Drawings

Exemplary embodiments are shown in the diagrammatic drawing and are explained in the description below. The following are shown:
- **Figs. 1a,b**: show schematic diagrams of two embodiments of an amplifier adapted for signal-specific output impedance matching, and
- **Figs. 2a,b**: show schematic diagrams of a base station with an active antenna element having an EER and an ET amplifier, respectively, both having an amplifier of the type shown in Fig. 1b.

### Detailed Description of Preferred Embodiments

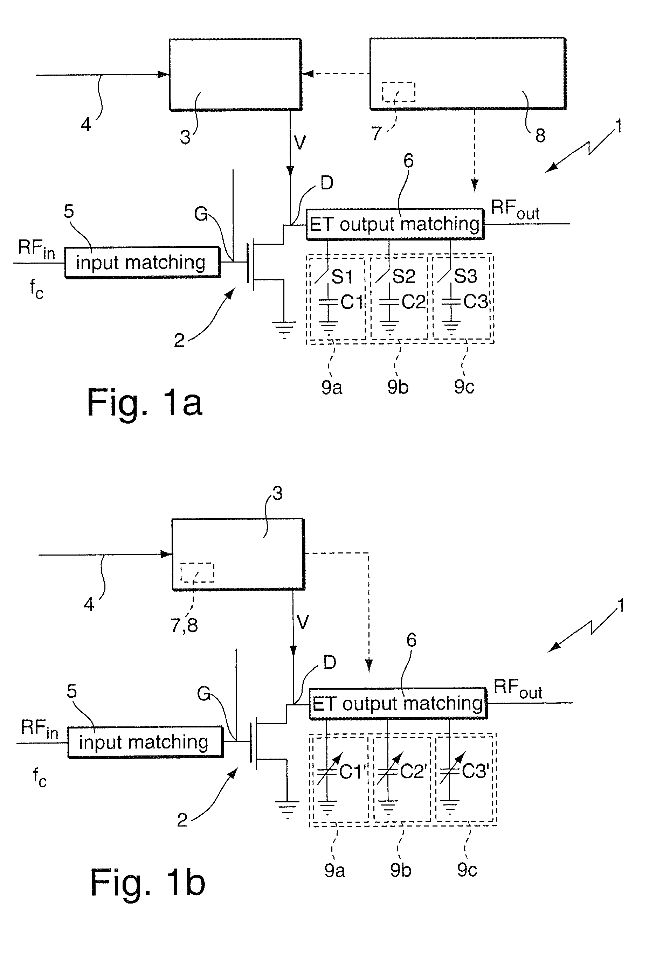

**Fig. 1a** shows an amplifier **1** for amplification of an RF input signal **"RF in".** The amplifier 1 comprises an output stage in the form of a power transistor **2,** in the present example being devised as a MOS-FET having a Gate terminal **G** and a Drain terminal **D.** The amplifier 1 is adapted for envelope tracking and comprises a modulator **3** to which an envelope signal **4** derived from the RF input signal "RF in" is provided. The (ET) modulator 3 generates a signal-dependent DC supply voltage which is provided as a bias voltage **V** to the drain terminal D of the power transistor 2. Likewise, a bias voltage (not shown) may be applied to the Gate terminal G of the power transistor 2.

The amplifier 1 further comprises a fixed input matching network 5 which is adapted to provide a desired input impedance, e.g. 50 Ohm, at a center frequency **f_{C}** of the RF input signal "RF in" which is to be amplified. In a similar way, an output matching network **6** is provided at the output (Drain terminal D) of the amplifier for providing an amplified RF output signal **"RF out"** which is impedance-matched to a desired output impedance, e.g. 50 Ohm, in the amplified wavelength band.

Although the input impedance and the output impedance of the single-band amplifier 1 are matched to the amplified frequency band, the output impedance may nevertheless not be optimized for the specific RF input signal "RF in" which is currently amplified, as the optimum output impedance depends on further characteristics of the RF input signal "RF in", in particular on its peak-to-average ratio.

As the peak-to-average ratio may vary depending on the communication standard used, an analyzing unit 7 is provided in the amplifier 1, being adapted to determine at least one statistical property of the currently amplified RF input signal "RF in". For this purpose, either the RF input signal "RF in" itself or the envelope signal 4 may be provided as an input to the analyzing unit 7. The analyzing unit 7 monitors the RF input signal "RF in" or the envelope signal 4, respectively, possibly also taking clipping into account, and determines a signal-specific supply voltage which is statistically most frequently required by the power transistor 2, the latter typically being an average of the supply voltage V which is provided to the Drain terminal D.

It will be understood that alternatively or in addition to the measuring of statistical properties of the RF input signal "RF in" or its envelope 4, respectively, the analyzing unit 7 may be adapted to use information about the RF input signal, in particular about the communication standard which is currently used, which is provided from an external device, e.g. from a baseband part of a base station (see below). In any case, the statistically most frequently required supply voltage V may be determined and provided to a control unit 8.

The control unit 8 is adapted to generate an optimum output impedance for the statistically most frequently required signal-specific supply voltage V. For this purpose, the control unit 8 is adapted to adjust a plurality of adaptive output impedance matching units **9a** to **9c** forming part of the output impedance matching network 6 in such a way that the desired optimum output impedance can be attained. The relation between the statistical property, e.g. the average value, of the adaptive supply voltage to the optimum output impedance may be determined beforehand, i.e. during the design of the amplifier 1, e.g. being based on experiment or calculations. The characteristic curve may the be stored in a memory, possibly in a look-up table provided in the amplifier 1. Moreover, the information provided by the analyzing unit 7 may also be used in the modulator 3, which may adapt its output, i.e. the supply voltage V, based e.g. on the peak-to-average ratio of the RF input signal "RF in".

In the example of Fig. 1a, each of the output impedance matching units 9a to 9c comprises a respective switching element, **S1** to **S3**, for example a PIN diode, for activating or deactivating at least one capacitor **C1** to **C3** which forms an impedance matching element having fixed impedance. Choosing appropriate (different) capacitances for the capacitors C1 to C3 and adapting the length of the RF line sections from the capacitors C1 to C3 to the output (Drain terminal D) of the power transistor 2 during the amplifier design allows one to adapt the output to the RF input signal impedance in a desired way. One skilled in the art will appreciate that more (or less) than the three adaptive output impedance matching units 9a to 9c shown in Fig. 1a may be arranged in the amplifier 1, the number being chosen depending on the desired precision of the adjustment. Also, other impedance matching elements, for example inductances and/or resistances, may be used.

Depending on the particular currently used RF input signal and addressed standard, the specific corresponding adaptive matching element C1 to C3 can be switched active by a respective one of the switches S1 to S3 in order to optimize the output matching and thus overall performance of the amplifier 1. In parallel, the ET modulator 3 may also be adjusted in a signal- and standard-related way, the control unit 8 being connected to the modulator 3 for this purpose.

It will be understood that for performing the adaptive matching, either switchable impedance matching elements C1 to C3 as shown in Fig. 1a, or tunable impedance matching elements **C1**' to **C3'** may be used, e.g. in the form of tunable capacitors as shown in **Fig. 1b****.** The respective capacitances of the tunable capacitors C1' to C3' may be adjusted by the control unit 8, each capacitor C1' to C3' having an individual dynamic range of capacitance values for which the adjustment may be performed.

Moreover, the amplifier 1 of Fig. 1b differs from the amplifier 1 of Fig. 1a in that it is devised as a multi-band amplifier, i.e. the transistor 2 is adapted for amplifying signals of different wavelength bands. For allowing impedance matching to the currently amplified frequency band, resp., center frequency f_{C}, the input and output impedance matching networks 5, 6 may comprise further switchable or tunable impedance matching elements (not shown for the sake of simplicity). It will be understood that in this case, the frequency-dependent output matching and the signal-specific output matching may be combined, i.e. adaptive output impedance matching units of the type shown in Fig. 1a or Fig. 1b may be designed in such a way that both signal-specific and frequency-dependent output matching may be performed.

The amplifier 1 shown in Fig. 1b further differs from the amplifier 1 of Fig. 1a in that the control unit 8 and the analyzing unit 7 are integrated into the modulator 3 or the digital baseband signal processing unit, thus providing a compact amplifier arrangement 1 which may very easily be implemented on a circuit board (RF line card).

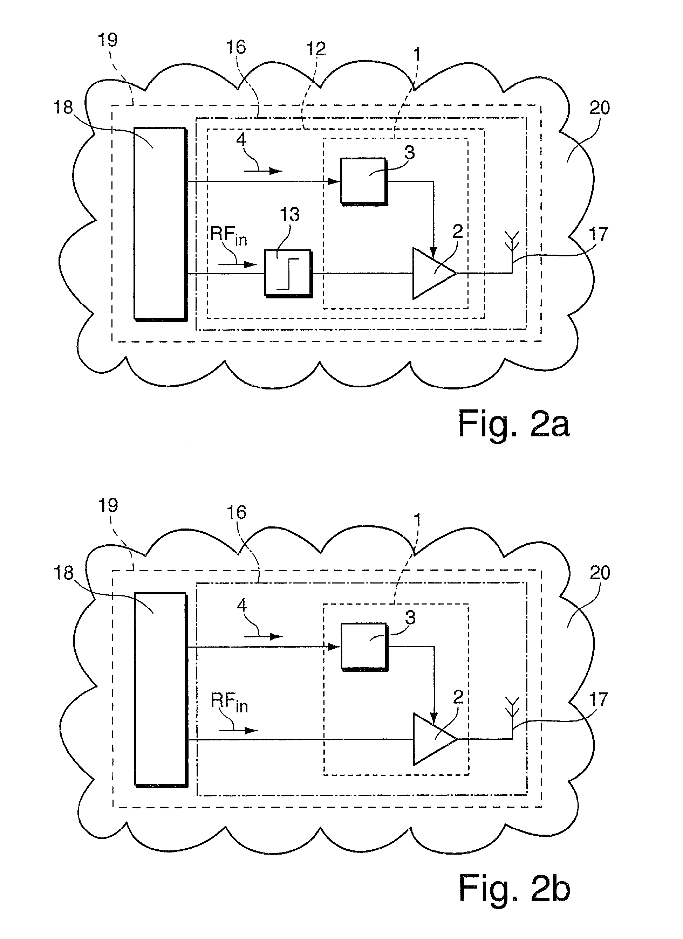

The amplifier 1 as described in Figs. 1a and 1b may be advantageously used as part of an EER amplifier **12** shown in **Fig. 2a****,** the latter comprising a limiter **13** at the input to the output stage 2, the latter being driven in switching operation. As shown in **Fig. 2b****,** the amplifier 1 may be used as an ET amplifier, in which case the power transistor 2 is used in a similar way as a class-A/B amplifier (i.e. not as a switch), no limiter being required in this case.

The EER amplifier 12 and the ET amplifier 1, respectively, may be part of an active antenna element **16** which provides the amplified RF signal to an antenna **17** for radio transmission. Both the envelope signal 4 and the RF input signal "RF in" may be provided to the EER or ET amplifier 12, 1 by a baseband part **18** of a transmit frontend of a base station **19** which may itself be part of a radio communication network **20.** The active antenna element 16 may constitute one of a plurality of antenna elements (not shown) being connected to the baseband part 18 of the base station 19. The person skilled in the art will appreciate that instead of providing the envelope signal 15 in the baseband part 18, the latter may also be derived from the RF input signal 2 in the EER amplifier 12 or in ET amplifier 1, respectively, e.g. by using a tap coupler and an envelope detector.

Moreover, the current load situation of the base station 19 (e.g. Base Transceiver Station, BTS) may also be taken into account for the output impedance matching. For this purpose, information about the load situation which is present e.g. in the baseband part 18 may be provided to the control unit 8 or the analyzing unit 7, respectively, for adjusting the output impedance accordingly. One skilled in the art will appreciate that the load condition of the base station 18 may also be used for the adaptation of the modulator 3, i.e. the load condition may have an influence on the supply voltage V which is provided to the output stage 2.

As already described above, different signals and communication standards require different (among others related to the signal statistics) supply voltages. Since the amplifier's output matching is supply-voltage dependent, only an optimum design for one specific signal/standard can be achieved. By use of the proposed signal- and standard-related adaptive matching, the output matching and thus the amplifier characteristic can be improved for different signals/standards. Thus, improved efficiency for multi-standard ET or EER amplifiers may be provided, leading to reduced amplifier capital expenditure (e.g. reduced development time, less required peak power and thus transistor size, etc.) as well as operating expenditure (improved efficiency, reduced cooling effort, etc.) and may thus support efficiency-improved Software-Defined Radio or Cognitive Radio.

The description and drawings merely illustrate the principles of the invention. It will thus be appreciated that those skilled in the art will be able to devise various arrangements that, although not explicitly described or shown herein, embody the principles of the invention and are included within its scope. Furthermore, all examples recited herein are principally intended expressly to be only for pedagogical purposes to aid the reader in understanding the principles of the invention and the concepts contributed by the inventor(s) to furthering the art, and are to be construed as being without limitation to such specifically recited examples and conditions. Moreover, all statements herein reciting principles, aspects, and embodiments of the invention, as well as specific examples thereof, are intended to encompass equivalents thereof.

## Claims

1. Amplifier (1) for amplification of an RF input signal (RF in), comprising:
an output stage (2),
a modulator (3) for providing a signal-specific supply voltage (V) to the output stage (2) based on an envelope (4) of the RF input signal (RF in),
and
at least one adaptive output impedance matching unit (9a to 9c) for adapting an output impedance of the output stage (2), wherein
the amplifier (1) is designed to adapt the at least one adaptive output matching unit (9a to 9c) based on the signal-specific supply voltage (V) that is provided to the output stage (2) and preferably also based on a specific load situation.

2. Amplifier according to claim 1, being designed to derive at least one statistical property, in particular a mean value, from the signal-specific supply voltage (V) and to adapt the at least one adaptive output matching unit (9a to 9c) based on the at least one derived statistical property.

3. Amplifier according to claim 1, wherein the output stage comprises an amplifying transistor (2), in particular a Field-Effect transistor, to which the signal-specific supply voltage (V) is provided.

4. Amplifier according to claim 1, wherein at least one of the adaptive output matching units (9a to 9c) comprises a switching element (S1 to S3) for activating or deactivating at least one impedance matching element (C1 to C3) having fixed impedance.

5. Amplifier according to claim 1, wherein at least one of the adaptive output matching units (9a to 9c) comprises a tunable impedance matching element (C1' to C3').

6. Amplifier according to claim 1, wherein the modulator (3) is adapted to generate the supply voltage (V) taking into account at least one statistical property, in particular a peak-to-average ratio, of the RF input signal (3).

7. Envelope Elimination and Restoration, EER, amplifier (12) comprising:
an amplifier (1) according to claim 1, and
a limiter (13) for limiting the RF input signal (RF in) which is provided to the output stage (2).

8. Base station (19) comprising at least one amplifier (1) according to claim 1.

9. Base station according to claim 9, wherein the amplifier (1) is designed for adapting the at least one adaptive output matching unit (9a to 9c) based on a load condition of the base station (19).

10. Communication network (20) comprising at least one base station (19) according to claim 9.

11. Method for power amplification of an RF input signal (RF in) in an amplifier (1), in particular of a base station (19) of a communications network (20), the method comprising:
adjusting an output impedance of an output stage (2) of the amplifier (1) by adapting at least one adaptive output matching unit (9a to 9c) of the output stage (2) based on a signal-specific supply voltage (V) that is provided from a modulator (3) to the output stage (2) and preferably also based on a specific load situation.

12. Method according to claim 12, wherein the step of adapting the at least one adaptive output matching unit (9a to 9c) comprises deriving at least one statistical property, in particular a mean value, of the signal-specific supply voltage (V), and adapting the at least one adaptive output matching unit (9a to 9c) based on the at least one derived statistical property.

13. Method according to claim 12, further comprising: adapting the modulator (3) for generating the supply voltage (V) based on a statistical property, in particular a peak-to-average-ratio, of the RF input signal (RF in) and/or based on a load condition of the base station (19).

## Amended claims

### Amended claims in accordance with Rule 137(2) EPC.

**1.** Amplifier (1) for amplification of an RF input signal (RF in), comprising:
an output stage (2),
a modulator (3) for providing a signal-specific supply voltage (V) to the output stage (2) based on an envelope (4) of the RF input signal (RF in), and
at least one adaptive output impedance matching unit (9a to 9c) for adapting an output impedance of the output stage (2), wherein
the amplifier (1) is designed to adapt the at least one adaptive output matching unit (9a to 9c) based on the signal-specific supply voltage (V) that is provided to the output stage (2),
**characterized in that**
for optimizing the output impedance of the output stage (2) for RF input signals (RF in) of different communication standards, the amplifier (1) is designed to derive at least one statistical property from the signal-specific supply voltage (V) and to adapt the at least one adaptive output matching unit (9a to 9c) based on the at least one derived statistical property.

**2.** Amplifier according to claim 1, wherein the output stage comprises an amplifying transistor (2) to which the signal-specific supply voltage (V) is provided.

**3.** Amplifier according to claim 1, wherein at least one of the adaptive output matching units (9a to 9c) comprises a switching element (S1 to S3) for activating or deactivating at least one impedance matching element (C1 to C3) having fixed impedance.

**4.** Amplifier according to claim 1, wherein at least one of the adaptive output matching units (9a to 9c) comprises a tunable impedance matching element (C1' to C3').

**5.** Amplifier according to claim 1, wherein the modulator (3) is adapted to generate the supply voltage (V) taking into account at least one statistical property of the RF input signal (3).

**6.** Envelope Elimination and Restoration, EER, amplifier (12) comprising:
an amplifier (1) according to claim 1, and
a limiter (13) for limiting the RF input signal (RF in) which is provided to the output stage (2).

**7.** Base station (19) comprising at least one amplifier (1) according to claim 1.

**8.** Base station according to claim 7, wherein the amplifier (1) is designed for adapting the at least one adaptive output matching unit (9a to 9c) based on a load condition of the base station (19).

**9.** Communication network (20) comprising at least one base station (19) according to claim 8.

**10.** Method for power amplification of an RF input signal (RF in) in an amplifier (1), the method comprising:
adjusting an output impedance of an output stage (2) of the amplifier (1) by adapting at least one adaptive output matching unit (9a to 9c) of the output stage (2) based on a signal-specific supply voltage (V) that is provided from a modulator (3) to the output stage (2),
**characterized in that**
for optimizing the output impedance of the output stage (2) for RF input signals (RF in) of different communication standards, the step of adapting the at least one adaptive output matching unit (9a to 9c) comprises deriving at least one statistical property of the signal-specific supply voltage (V), and adapting the at least one adaptive output matching unit (9a to 9c) based on the at least one derived statistical property.

**11.** Method according to claim 10, further comprising: adapting the modulator (3) for generating the supply voltage (V) based on a statistical property of the RF input signal (RF in).
